(19) Europäisches Patentamt
European Patent Office
Office européen des brevets

(11) EP 0 589 767 B1

(12) FASCICULE DE BREVET EUROPEEN

(45) Date de publication et mention de la délivrance du brevet:
**27.12.1996 Bulletin 1996/52**

(51) Int Cl.$^6$: **H03H 17/02**

(21) Numéro de dépôt: **93402288.0**

(22) Date de dépôt: **20.09.1993**

(54) **Procédé pour déterminer la transmittance d'un circuit de filtrage prévu pour transformer la réponse impulsionnelle d'un filtre en une réponse à phase minimale et filtre mettant en oeuvre ce procédé**

Verfahren zur Bestimmung der Transmittanz einer Filterschaltung zur Umwandlung der Impulsantwort eines Filters in eine Impulsantwort mit minimaler Phase und Filter zur Durchführung des Verfahrens

Method for determining the transmittance of a filter circuit for transforming a filter impulse response in a minimum phase response and filter circuit using this method

(84) Etats contractants désignés:
**AT BE CH DE DK ES FR GB IT LI NL SE**

(30) Priorité: **25.09.1992 FR 9211467**

(43) Date de publication de la demande:
**30.03.1994 Bulletin 1994/13**

(73) Titulaires:
• **ALCATEL N.V.**
**NL-1077 XX Amsterdam (NL)**
Etats contractants désignés:
**BE CH DE DK ES GB IT LI NL SE AT**
• **ALCATEL MOBILE COMMUNICATION FRANCE**
**75008 Paris (FR)**
Etats contractants désignés:
**FR**

(72) Inventeurs:
• **Mourot, Christophe**
**F-92600 Asnieres (FR)**
• **Wautier, Armelle**
**F-91190 Gif Sur Yvette (FR)**
• **Dany, Jean-Claude**
**F-91190 Gif Sur Yvette (FR)**

(74) Mandataire: **Schaub, Bernard et al**
**c/o ALCATEL ALSTHOM,**
**Département de Propriété Industrielle,**
**30, avenue Kléber**
**75116 Paris (FR)**

(56) Documents cités:
• ELECTRONICS LETTERS. vol. 22, no. 23 , 6 Novembre 1986 , ENAGE GB pages 1225 - 1227 G.R.REDDY 'DESIGN OF MINIMUM-PHASE FIR DIGITAL FILTER THROUGH CEPSTRUM'
• IEEE TRANSACTIONS ON ACOUSTICS, SPEECH AND SIGNAL PROCESSING vol. 26, no. 3 , Juin 1978 , NEW YORK US pages 226 - 235 SATOSHI IMAI 'DIGITAL FILTER DESIGN IN THE QUEFRENCY DOMAIN'

**Description**

La présente invention concerne un procédé pour déterminer la transmittance d'un circuit de filtrage prévu pour transformer la réponse impulsionnelle d'un filtre en une réponse à phase minimale.

Elle vise également un circuit de filtrage obtenu par mise en oeuvre de ce procédé.

Une réponse est dite à phase minimale lorsque sa transformée en z n' a de zéro qu'à l'intérieur du cercle unité dans le plan complexe.

Jusqu'à présent, on effectuait soit une recherche systématique de tous les zéros de la fonction de transfert associée à la réponse impulsionnelle à transformer et on réalisait l'extraction de ceux dont le module est supérieur ou égal à 1, soit une recherche des seuls zéros de module supérieur ou égal à 1, comme cela est divulgué dans l'article "adaptive adjustment of receiver for distorted digital signals" (réglage adaptatif d'un récepteur de signaux numériques distordus) IEE Proc. Part F (Août 1984) Vol 131, pp526-536.

Cependant, ces méthodes ont une précision limitée et leur complexité augmente avec la longueur du filtre. En outre, le nombre d'opérations à effectuer est une variable aléatoire et le temps de convergence est variable.

Le but de l'invention est de remédier à ces inconvénients en proposant un procédé pour déterminer la transmittance d'un circuit de filtrage associé à un filtre présentant une réponse impulsionnelle H(z), ce circuit de filtrage étant prévu pour que la réponse impulsionnelle globale G(z) du filtre et du circuit de filtrage soit à phase minimale, ce procédé présentant un temps de convergence fixe et étant de complexité réduite.

Suivant l'invention, le procédé comprend:

- une détermination de la réponse en fréquence H(f) du filtre par transformée de Fourier de la réponse impulsionnelle H(z) de ce filtre ,
- une détermination de la partie réelle a(f) du cepstre $\hat{H}$(f) = -ln(H(f)) de la réponse impulsionnelle H(f) du filtre pour extraire de cette partie réelle a(f) une partie paire p(f) et une partie impaire q(f),
- une détermination du cepstre $\hat{G}$(f) = -ln(G(f)) de la réponse globale en fréquence à partir de ces parties paire p(f) et impaire q(f) du cepstre $\hat{H}$(f) de la réponse impulsionnelle du filtre,
- une détermination de la réponse globale en fréquence G(f) à partir du cepstre $\hat{G}$(f) de cette réponse,
- une détermination de la réponse théorique en fréquence C(f) du circuit de filtrage au moyen de la réponse globale en fréquence G(f) et de la réponse en fréquence H(f) du filtre,
- un calcul de la transmittance théorique C(z) du circuit de filtrage par transformée de Fourier inverse de la réponse en fréquence C(f) de ce circuit et,
- une détermination de la transmittance P(z) du circuit de filtrage par troncature de la transmittance C(z) dont ne sont conservés qu'un nombre prédéterminé de coefficients.

Ainsi, le procédé selon l'invention permet de concentrer l'énergie dans les premiers échantillons de la réponse impulsionnelle fournie en sortie et la transforme en réponse à phase minimale.

Ce procédé met en oeuvre le principe du cepstre qui est fondé sur la causalité de la réponse impulsionnelle $\hat{G}$(z) = - ln(G(z)) qui est obtenue lorsque la réponse impulsionnelle G(z) est à phase minimale.

Selon une forme préférée de mise en oeuvre du procédé selon l'invention, on procède à une estimation de la réponse impulsionnelle globale G(z) à partir d'un développement limité du cepstre $\hat{G}$(z).

Le procédé selon l'invention peut comprendre en outre l'obtention d'une première estimation $\tilde{g}_0$(z) de la réponse globale à phase minimale G(z) comportant:

- un calcul des coefficients de la réponse impulsionnelle à phase minimale G(z) par transformée de Fourier discrète inverse de la réponse en fréquence à phase minimale G(f), et
- la conservation d'un nombre prédéterminé de coefficients significatifs pour obtenir ladite estimation $\tilde{g}_0$(z).

Suivant un autre aspect de l'invention, il est proposé un circuit de filtrage numérique transversal correcteur de phase, prévu pour transformer une réponse impulsionnelle d'un fitre en une réponse à phase minimale. Des moyens de calcul algorithmique sont associés au cicuit de filtrage pour en adapter les coefficients par mise en oeuvre du procédé selon l'invention.

D'autres particularités et avantages de l'invention apparaîtront encore dans la description ci-après.

Aux dessins annexés donnés à titre d'exemples non limitatifs:

- La figure 1 est un schéma-bloc d'un dispositif de réception incluant un circuit de filtrage selon l'invention,
- la figure 2 illustre la variation de l'énergie de la réponse impulsionnelle globale d'un filtre et du circuit de filtrage selon l'invention en fonction du temps,
- les figures 3 à 5 illustrent l'amélioration apportée par un circuit de filtrage selon l'invention en représentant l'évolution de taux d'erreur binaire à la sortie d'un récepteur en fonction du rapport de l'énergie moyenne par bit en sortie du filtre sur la densité spectrale unilatérale de puissance d'un bruit blanc additif gaussien pour des configurations de canal suivantes:

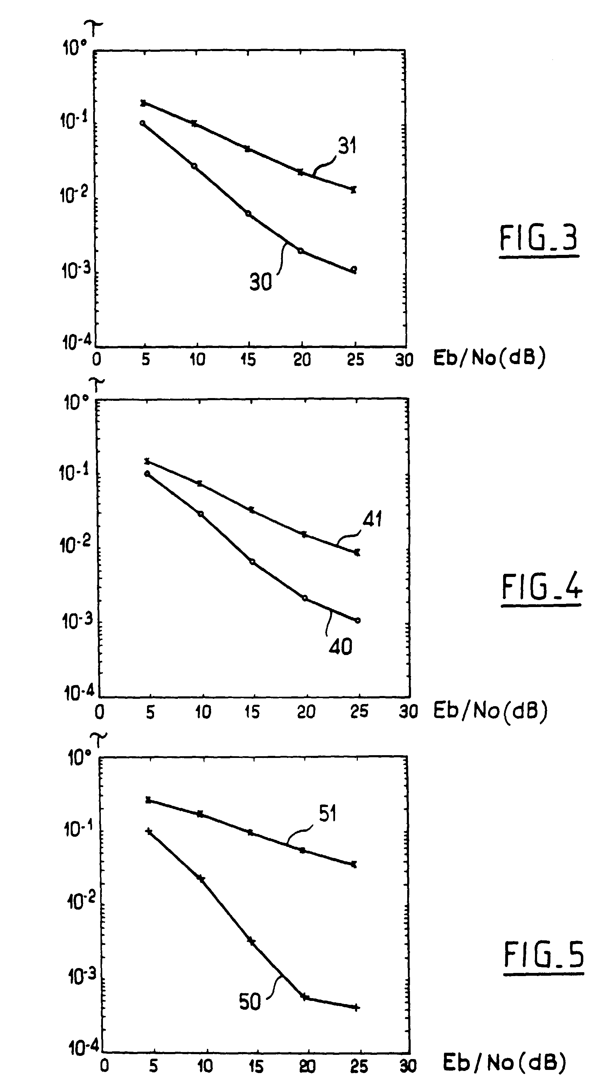

* figure 3: canal à deux trajets d'égales puissances,
* figure 4: canal à deux trajets de puissances inégales,
* figure 5: canal à trois trajets d'égales puissances.

On va maintenant décrire un exemple de mise en oeuvre du procédé selon l'invention au sein d'un dispositif de réception.

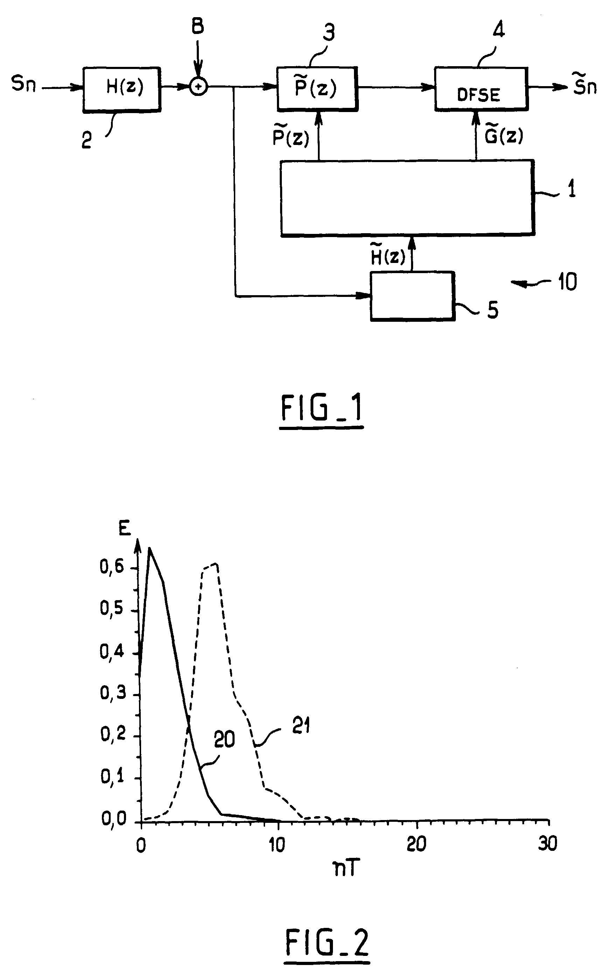

Le récepteur 10, représenté sous la forme d'un schéma-bloc en figure 1, est agencé pour recevoir des symboles Sn émis en entrée d'un filtre 2, par exemple un canal de transmission 2, présentant une réponse impulsionnelle H(z) échantillonnée à une fréquence prédéterminée 1/T, où T est une période d'échantillonnage. A ces symboles est ajouté au cours de la transmission, du bruit B. Le récepteur 10 selon l'invention comprend un circuit de filtrage 3 prévu pour transformer la réponse impulsionnelle globale en une réponse à phase minimale et situé en amont d'un détecteur 4 de type DFSE (Decision feedback Sequence Estimator: Estimateur de séquence à Réaction de Décision)qui génère des symboles de réception $\check{s}n$, des moyens 5 pour estimer le filtre et calculer une estimation $\tilde{\check{h}}(z)$ de la réponse impulsionnelle du filtre, et des moyens 1 pour calculer un algorithme d'adaptation des coefficients du circuit de filtrage 3 qui matérialise le procédé selon l'invention. Les moyens de calcul 1 génèrent une estimation $\bar{\check{p}}(z)$ de la transmittance P (z) du circuit de filtrage 3 qui est un filtre numérique transversal de réponse impulsionnelle finie approchant un filtre correcteur de phase idéal de réponse impulsionnelle infinie, et une estimation $\tilde{\check{g}}(z)$ de la réponse impulsionnelle à phase minimale en sortie du circuit de filtrage 3.

Soient:

H(z) la transformée en z de la réponse impulsionnelle du filtre échantillonnée à la fréquence 1/T,
G(z) la transformée en z de la réponse globale à phase minimale,
C(z) la transmittance en z du circuit de filtrage.

$$H(z)=\sum_{n=0}^{K} h_n z^{-n} \qquad G(z)=\sum_{n=0}^{K} g_n z^{-n} \qquad H(z)\,C(z)=G(z)$$

où K est la longueur du filtre.

Si on considère dans un premier temps le cas où H(z) n'a pas de zéro sur le cercle unitaire, p zéros à l'intérieur de ce cercle notés $\alpha_i$, q zéros à l'extérieur notés $\beta_j$:

$$(1) \qquad H(z)=h_0 \prod_{i=1}^{p}(1-\alpha_i z^{-1}) \prod_{j=1}^{q}(1-\beta_{jz}^{-1}) \qquad |\alpha_i|<1 \; |\beta_j|>1 \; K=p+q$$

La propriété de phase minimale sur G(z) impose pour G(z) et C(z) les expressions suivantes:

$$(2) \qquad G(z)=h_0 \prod_{j=1}^{q}\beta_j^* \prod_{i=1}^{p}(1-\alpha_i z^{-1}) \prod_{j=1}^{q}(1-\frac{1}{\beta_j^*}z^{-1})$$

avec le sigle * représentant l'opération de conjugaison.

La transmittance théorique C(z) du circuit de filtrage passe-tout et de gain unitaire peut s'exprimer de la façon suivante:

$$(3) \qquad C(z) = \frac{\displaystyle\prod_{j=1}^{q} (1 - \beta_j' z)}{\displaystyle\prod_{j=1}^{q} \beta_j \displaystyle\prod_{j=1}^{q} (1 - \frac{1}{\beta_j} z)}$$

Les pôles de la transmittance $C(z)$ étant à l'extérieur du cercle unitaire, on peut développer $C(z)$ sous la forme suivante:

$$(4) \qquad C(z) = \frac{\displaystyle\prod_{j=1}^{q} (1 - \beta_j' z)}{\displaystyle\prod_{j=1}^{q} \beta_j} \prod_{j=1}^{q} (1 + \frac{1}{\beta_j} z + \ldots + \frac{1}{\beta_j^n} z^n + \ldots)$$

qui peut être représenté sous la forme d'une série:

$$(5) \qquad C(z) = \sum_{n=0}^{\infty} c_n z^n$$

Les coefficients $C_n$ constituent une suite qui tend vers 0 lorsque n tend vers l'infini et $C(z)$ est la transmittance d'un filtre idéal anticausal à réponse impulsionnelle infinie stable. Une troncature du développement de la transmittance $C(z)$ à un ordre prédéterminé L permet une réalisation pratique avec un filtre numérique transversal de longueur finie. La transmittance de ce filtre peut s'exprimer sous la forme polynômiale suivante:

$$(6) \qquad P(z) = c_0 + c_1 z + \ldots + c_L z^L$$

La réponse obtenue après passage dans le filtre de transmittance $P(z)$ s'écrit :

$$(7) \qquad H(z).P(z) = G(z) + \sum_{n=L+1-K}^{L} \varepsilon_n z^n \qquad \text{pour } L \geq K$$

En effet,

$$H(z) P(z) = H(z) \left( C(z) - \sum_{n=L+1}^{\infty} c_n z^n \right)$$

$$= G(z) - H(z) \sum_{n=L+1}^{\infty} c_n z^n$$

Les termes en $z^{-n}$ de $H(z)$ sont nuls pour m>K tandis que les termes en $z^k$ de $H(z)P(z)$ sont nuls pour k>L. on peut donc transformer le deuxième terme du deuxième membre de l'équation précédente comme suit :

$$H(z). \sum_{n=L+1}^{+\infty} c_n z^n \quad \Rightarrow \quad \sum_{n=L+1-K}^{L} \varepsilon_n z^n$$

Si, par exemple, $H(z)=h_o(1-\beta z^{-1})$, alors l'expression (7) peut s'écrire de la façon suivante:

$$(8) \qquad H(z)\, P(z) = G(z) + h_0\ (\frac{1}{\beta^{L+1}} - \frac{\beta^*}{\beta^L}) z^L$$

La troncature du filtre peut être adoucie en la pondérant par une fenêtre.

Lorsque la réponse impulsionnelle $H(z)$ possède des zéros sur le cercle unitaire, ceux-ci ne sont pas affectés par le filtre. L'expression de la transmittance théorique $C(z)$ exprimée par l'équation (3) précitée reste inchangée mais les équations (1) et (2) deviennent:

$$(9) \qquad H(z)=h_0 \prod_{i=1}^{p}(1-\alpha_i z^{-1})\ \prod_{j=1}^{q}(1-\beta_j z^{-1})\ \prod_{i=1}^{r}(1-\gamma_i z^{-1})$$
$$|\alpha_i|<1 \quad |\beta_j|>1 \quad |\gamma_j|=1 \quad K=p+q+r$$

et la réponse à phase minimale s'exprime de la façon suivante:

$$(10) \qquad G(z)=h_0 \prod_{j=1}^{q}\beta_j \prod_{i=1}^{p}(1-\alpha_i z^{-1})\ \prod_{j=1}^{q}(1-\frac{1}{\beta_j}z^{-1})\ \prod_{i=1}^{r}(1-\gamma_i z^{-1})$$

Le procédé selon l'invention met en oeuvre la méthode du cepstre fondée sur le fait que la causalité de la réponse impulsionnelle du filtre de transmittance $\hat{G}(z) = -\ln(G(z))$ est obtenue lorsque le filtre de transmittance $G(z)$ est à phase minimale.

Pour $[z_{oi}]<1$, on peut écrire:

$$-\ \ln(1-z_{0i} z^{-1}) = -\sum_{n=1}^{\infty}\frac{1}{n} z_{0i}^{n} z^{-n}$$

On peut en déduire un développement pour le cepstre $\hat{G}(z)$:

$$(11) \qquad \hat{G}(z)=\ln g_0 -\sum_{i=1}^{p+q}\sum_{n=1}^{\infty}\frac{1}{n} z_{0i}^{n} z^{-n}\quad \text{avec}\ G(z)=g_0\sum_{j=1}^{p+q}(1-z_{0j} z^{-1})$$

$$(12) \qquad \hat{G}(z)=\sum_{n=0}^{\infty}\hat{g}_n z^{-n}\quad \text{avec}\quad \hat{g}_0=\ln(g_0)\quad \text{et}\quad \hat{g}_n=-\frac{1}{n}\sum_{j=1}^{p+q} z_{0j}^{n}\quad \text{pour}\quad n>0$$

On considère maintenant la réponse en fréquence $H(f)$ du filtre. En supposant que la réponse impulsionnelle n'a pas de zéro sur le cercle unitaire, le module $[H(f)]$ ne peut pas s'annuler et on peut écrire, pour les expressions respectives de la réponse en fréquence $H(f)$ du filtre, de la transmittance en fréquence à phase minimale $G(f)$ et de la transmittance en fréquence $C(f)$ du circuit de filtrage idéal:

$$(13) \qquad H(f) = e^{-a(f)-j\varphi(f)}$$

$$(14) \qquad G(f) = e^{-a(f)-j\theta(f)}$$

$$(15) \qquad C(f) = e^{j\varphi(f)-j\theta(f)} = H^{\bullet}(f)e^{a(f)-j\theta(f)}$$

Le cepstre $\hat{G}(f) = \ln(G(f)) = -a(f) - j\theta(f)$, s'écrit également:

$$\hat{G}(f) = \sum_{n=0}^{+\infty} \hat{g}_n e^{-j2\pi f n T}$$

$$= \sum_{n=0}^{+\infty} (\hat{g}_{1,n} \cos(2\pi f n T) + \hat{g}_{2,n} \sin(2\pi f n T)$$

$$+ j \sum_{n=0}^{+\infty} \hat{g}_{1,n} \sin(2\pi f n T) - \hat{g}_{2,n} \cos(2\pi f n T)$$

avec $\hat{g}_n = \hat{g}_{1,n} + j\hat{g}_{2,n}$

et il est possible de séparer a(f) en une partie paire p(f) et une partie impaire q(f) qui peuvent être exprimées de la façon suivante:

$$(16) \qquad p(f) = \frac{a(f) + a(-f)}{2} = -\sum_{n=0}^{\bullet} \hat{g}_{1,n} \cos(2\pi f n T)$$

$$(17) \qquad q(f) = \frac{a(f) - a(-f)}{2} = -\sum_{n=0}^{\bullet} \hat{g}_{1,n} \sin(2\pi f n T)$$

La partie imaginaire θ(f) du cepstre peut alors s'exprimer ainsi:

$$(18) \qquad \theta(f) = -\sum_{n=0}^{\bullet} (\hat{g}_{1,n} \sin(2\pi f n T) - \hat{g}_{2,n} \cos(2\pi f n T))$$

$$= \sum_{n=0}^{\bullet} T \sin(2\pi f n T) \int_{\frac{-1}{T}}^{\frac{1}{T}} p(\upsilon) \cos(2\pi \upsilon n T) d\upsilon$$

$$- \sum_{n=0}^{\bullet} T \cos(2\pi f n T) \int_{\frac{-1}{T}}^{\frac{1}{T}} q(\upsilon) \sin(2\pi \upsilon n T) d\upsilon$$

A partir de la phase θ(f) qui ne dépend que des parties paire et impaire de a(f), on peut calculer la transmittance en fréquence C(f) et la réponse à phase minimale G(f).

Les développements mathématiques qui viennent d'être présentés ont pour seul but de fournir les éléments nécessaires à la compréhension du fonctionnement de l'algorithme de détermination des coefficients du circuit de filtrage concrétisant le procédé selon l'invention , et l'exploitation pratique de cet algorithme va maintenant être expliquée.
Dans le cas où la réponse impulsionnelle H(z) du filtre n'a pas de zéro sur le cercle unitaire,

- la transformée H(f) est obtenue par transformée de Fourier, éventuellement transformée de Fourier rapide, de la réponse impulsionnelle H(z). Ce premier traitement qui comporte le calcul de $N=2^m$ échantillons nécessite $2mN$ multiplications et $3mN$ additions,
- l'obtention des quantités p(f) et q(f) met en oeuvre $2N$ multiplications et $3N$ additions,
- $\{\hat{g}_n\}$ est une suite décroissante qui tend vers zéro lorsque n tend vers l'infini. En limitant le développement de $\hat{G}(z)$ à l'ordre $N/2$, les coefficients $\hat{g}_{1,n}$ et $\hat{g}_{2,n}$ sont respectivement obtenus à l'aide de transformées en cosinus et en sinus inverses:

$$\text{Pour } n=0, n=\frac{N}{2} \quad \hat{g}_n = -\frac{1}{N}\left(\sum_{k=1}^{\frac{N}{2}-1} 2p\left(\frac{k}{NT}\right)\cos\left(2\pi\frac{nk}{N}\right) + p(0) + p\left(\frac{1}{2T}\right)(-1)^n\right)$$

$$\text{Pour } n\in[1, N/2-1] \quad \hat{g}_{1,n} = -\frac{2}{N}\left(\sum_{k=1}^{\frac{N}{2}-1} 2p\left(\frac{k}{NT}\right)\cos\left(2\pi\frac{nk}{N}\right) + p(0) + p\left(\frac{1}{2T}\right)(-1)^n\right)$$

$$\text{Pour } n\in[1, N/2-1] \quad \hat{g}_{2,n} = -\frac{2}{N}\left(\sum_{k=1}^{\frac{N}{2}-1} 2q\left(\frac{k}{NT}\right)\sin\left(2\pi\frac{nk}{N}\right)\right) \quad \text{et} \quad \hat{g}_{2,\frac{N}{2}}=0$$

La fixation arbitraire de $\hat{g}_{2,0}$ à zéro modifie les expressions (2) et (3) de la réponse à phase minimale G(z) et de la transmittance théorique C(z) qui deviennent:

$$(19) \qquad G(z)=|h_0|\prod_{j=1}^{q}(1-\alpha_i z^{-1})\prod_{j=1}^{q}\left(1-\frac{1}{\beta_j}z^{-1}\right)$$

$$(20) \qquad C(z) = \frac{h_0^* \prod_{j=1}^{q}(1-\beta_j^* z)}{|h_0|\prod_{j=1}^{q}|\beta_j|\prod_{j=1}^{q}\left(1-\frac{1}{\beta_j}z\right)}$$

Ces calculs mettent en oeuvre $4mN$ multiplications et $6mN$ additions.

- La phase $\theta(f)$ est la partie imaginaire de la transformée de Fourier rapide de la séquence complexe $\hat{g}_n = \hat{g}_{1,n} + j\hat{g}_{2,n}$ ; son calcul nécessite $2mN$ multiplications et $3mN$ additions.
- L'expression de la transformée de Fourier C(f) de la transmittance théorique du filtre peut se mettre sous la forme suivante:

$$(21) \qquad C(f) = H^*(f)e^{a(f)}(\cos\theta(f) - j\sin\theta(f))$$

Son calcul met en oeuvre 6N multiplications et 2N additions. La transmittance C(z) est obtenue par transformée de Fourier rapide inverse et nécessite 2mN multiplications et 3mN additions. L'estimation $\tilde{P}$ (z) de la transmittance du circuit de filtrage selon l'invention est obtenue à partir de la transmittance théorique C(z) dont on ne garde que les L+1 coefficients significatifs.

Au total, l'algorithme d'adaptation met en oeuvre:

- 10mN+8N multiplications
- 15mN+4N additions entre nombres réels, et
- aucune division.

On est bien en présence d'un algorithme non itératif et le nombre d'opérations n'est pas variable et ne dépend pas de la durée K de la réponse impulsionnelle à transformer, ni de l'ordre L de troncature de la transmittance C(z). Cependant, le nombre d'échantillons N doit satisfaire la relation suivante:

$$(22) \qquad N \geq L \geq K$$

Dans le cas où la réponse impulsionnelle H(z) du filtre a des zéros sur le cercle unitaire, il n'est plus possible de mettre en oeuvre la méthode du cepstre, mais il est encore possible d'utiliser l'algorithme qui vient d'être présenté par une modification heuristique consistant à remplacer l'expression de a(f) par l'expression suivante:

$$(23) \qquad a(f) = -1/2 \ln(H(f)H^*(f) + \varepsilon)$$

où $\varepsilon$ doit être choisi avec soin pour éviter soit la divergence de l'algorithme ($\varepsilon$ trop petit), soit une diminution des performances de l'algorithme ($\varepsilon$ trop grand). Les modifications mineures apportée à l'algorithme n'augmentent sa complexité que de N additions réelles et de N comparaisons réelles.

Les moyens de calcul algorithmique 1 délivrent une réponse estimée $\tilde{G}$ (z) de la réponse à phase minimale G(z). Cette réponse estimée peut revêtir deux formes:

- Une première forme d'estimation $\tilde{G}_o$ (z) est obtenue en ne gardant que les termes significatifs des coefficients du polynôme G(z) obtenu par transformée de Fourier discrète inverse de la transformée G(f) calculée à partir de a(f) et de θ(f). Le calcul de cette estimation nécessite 2mN+2N multiplications et 3mN additions.
- Une seconde forme d'estimation $\tilde{G}_1$ (z) est constituée par la partie causale du produit $H(z)\tilde{P}$ (z) et nécessite 2(K+1)(K+2) multiplications et K(K+1) additions entre nombres réels.

Dans un exemple d'application du procédé selon l'invention à un canal téléphonique, on a mis en évidence le transfert de l'énergie E de la réponse impulsionnelle globale du canal et du circuit de filtrage vers l'origine des temps, en référence à la figure 2 où les courbes 20, 21 représentent respectivement la variation de l'énergie E en fonction du temps échantillonné nT en présence et en l'absence du circuit de filtrage selon l'invention.

La mise en oeuvre du procédé selon l'invention dans un dispositif complet de réception tel que représenté sous forme d'un schéma-bloc en figure 1 a été simulée. Un tel dispositif de réception peut être utilisé dans des transmissions numériques avec des mobiles à accès multiple à répartition dans le temps (AMRT). Les messages sont émis sous la forme d'une succession d'intervalles de temps, au centre desquels est placée une séquence d'apprentissage permettant d'estimer la réponse du filtre et d'adapter les coefficients du circuit de filtrage en mettant en oeuvre le procédé selon l'invention.

A titre d'exemple non limitatif, on peut considérer sur le canal de transmission 2 une modulation d'amplitude en quadrature à quatre états, une mémoire du filtre prise en compte par le récepteur 10 de 6 symboles, un nombre d'états pris en compte dans l'algorithme de Viterbi modifié du détecteur DFSE 4 égal à 16, correspondant à une mémoire de 2 symboles seulement. L'intervalle de temps est constitué de 22 symboles d'apprentissage et de 144 symboles d'information.

Les performances du récepteur 10 sont évaluées par un taux d'erreur par bit $\tau$ en fonction du rapport de l'énergie moyenne Eb par bit en sortie du canal 2 sur la densité spectrale unilatérale de puissance No d'un bruit blanc additif gaussien. Différents profils de canaux ont été simulés:

- un premier canal c1 est un canal à deux trajets d'égales puissances distants de 6 échantillons de temps,
- un second canal c2 est un canal à deux trajets de puissances inégales, distants de 6 échantillons de temps,
- un troisième canal c3 est un canal à trois trajets d'égales puissances, situés respectivement aux instants 0, 3Ts et 6Ts, où Ts est la période d'échantillonnage.

En référence à la figure 3 qui correspond au cas du premier canal c1, les courbes 31 et 30 représentent respectivement l'évolution du taux d'erreur binaire $\tau$ en fonction du rapport Eb/No dans un dispositif récepteur non muni d'un circuit de filtrage selon l'invention ($*$) et dans un dispositif récepteur équipé d'un circuit de filtrage selon l'invention (o). On observe que le taux d'erreur est systématiquement diminué en présence d'un circuit de filtrage et que l'amélioration croît significativement avec l'énergie moyenne.

Dans le cas du canal c2 à deux trajets de puissances inégales illustré en figure 4, l'amélioration du taux d'erreur binaire est encore très significative, l'écart entre les deux courbes 40, 41 étant sensiblement inférieur à celui observé dans le canal c1.

Dans le cas du canal c3 à trois trajets d'égales puissances illustré en figure 5, l'écart entre les courbes 50, 51 de taux d'erreur binaire correspondant respectivement à la présence et à l'absence d'un circuit de filtrage selon l'invention est particulièrement important, en particulier pour des niveaux élevés d'énergie moyenne.

Bien sûr, l'invention n'est pas limitée aux exemples qui viennent d'être décrits et de nombreux aménagements peuvent être apportés à ces exemples sans sortir du cadre de l'invention.

Ainsi, le procédé selon l'invention peut s'appliquer à un nombre quelconque de réponses impulsionnelles. Le nombre de zéros de la réponse impulsionnelle d'un canal ne constitue pas non plus une entrave à l'application de ce procédé, qui ne peut être éventuellement limitée que par les capacités de calcul rapide mises en oeuvre pour exécuter l'algorithme d'adaptation.

## Revendications

1. Procédé pour déterminer la transmittance P(z) d'un circuit de filtrage (3) associé à un filtre (2) présentant une réponse impulsionnelle H(z) caractérisé en ce que, ledit circuit de filtrage (3) étant prévu pour que la réponse impulsionnelle globale G(z) dudit filtre (2) et de ce circuit (3) soit à phase minimale, il comprend :

   - une détermination de la réponse en fréquence H(f) dudit filtre (2) par transformée de Fourier de la réponse impulsionnelle H(z) de ce filtre (2),
   - une détermination de la partie réelle a(f) du cepstre $\hat{H}(f) = -\ln(H(f))$ de la réponse impulsionnelle H(f) dudit filtre (2) pour extraire de cette partie réelle a(f) une partie paire p(f) et une partie impaire q(f),
   - une détermination du cepstre $\hat{G}(f) = -\ln(G(f))$ de la réponse globale en fréquence à partir desdites parties paire p(f) et impaire q(f) du cepstre $\hat{H}(f)$ de la réponse impulsionnelle dudit filtre (2),
   - une détermination de la réponse globale en fréquence G(f) à partir du cepstre $\hat{G}(f)$ de cette réponse,
   - une détermination de la réponse théorique en fréquence C(f) dudit circuit de filtrage (3) au moyen de la réponse globale en fréquence G(f) et de la réponse en fréquence H(f) dudit filtre (2),
   - un calcul de la transmittance théorique C(z) dudit circuit de filtrage (3) par transformée de Fourier inverse de la réponse en fréquence C(f) de ce circuit (3) et,
   - une détermination de la transmittance P(z) dudit circuit de filtrage (3) par troncature de la transmittance C(z) dont ne sont conservés qu'un nombre prédéterminé de coefficients.

2. Procédé selon la revendication 1, caractérisé en ce qu'il permet une estimation de la réponse impulsionnelle globale G(z) à partir d'un développement limité du cepstre $\hat{G}(z)$.

3. Procédé selon l'une des revendications 1 ou 2, caractérisé en ce qu'il comprend en outre l'obtention d'une première estimation $\tilde{G}_o (z)$ de la réponse à phase minimale G(z) comportant:

   - un calcul des coefficients de la réponse impulsionnelle à phase minimale G(z) par transformée de Fourier discrète inverse de la réponse en fréquence à phase minimale G(f), et
   - la conservation d'un nombre prédéterminé de coefficients significatifs pour obtenir ladite estimation $\tilde{G}_o (z)$.

4. Procédé selon l'une quelconque des revendications précédentes, caractérisé en ce qu'il comprend en outre l'obtention d'une deuxième estimation $\tilde{G}_1 (z)$ sous la forme de la partie causale du produit de la réponse impulsionnelle du filtre H(z) et de l'estimation $\tilde{P}(z)$ de la transmittance P(z) du filtre (3).

5. Procédé selon l'une quelconque des revendications précédentes, caractérisé en ce qu'il comprend un nombre d'opérations à effectuer et un temps de calcul fixes et indépendants de la longueur du filtre H(z), et en ce que lesdits développements limités et lesdites transformées ont des tailles prédéterminées.

**6.** Procédé selon l'une quelconque des revendications précédentes, caractérisé en ce qu'il comprend en outre un traitement heuristique du cas où la réponse impulsionnelle H(z) du filtre (2) a des zéros sur le cercle unité, par la modification suivante:

$$a(f) = -1/2 \ln(H(f)H^*(f) + \varepsilon),$$

$\varepsilon$ représentant un paramètre de réglage.

**7.** Circuit de filtrage numérique transversal correcteur de phase (3) associé à un filtre (2) et prévu pour que la réponse impulsionnelle globale dudit filtre (2) et dudit circuit de filtrage (3) soit à phase minimale, comprenant des moyens de calcul algorithmique (1) associés audit circuit de filtrage correcteur (3) pour en adapter les coefficients par mise en oeuvre du procédé selon l'une quelconque des revendications précédentes.

**Patentansprüche**

**1.** Verfahren zur Bestimmung der Transmittanz P(z) einer Filterschaltung (3) in Verbindung mit einem Filter (2), das eine Impulsantwort H(z) besitzt, dadurch gekennzeichnet, daß für eine Filterschaltung (3), die so ausgebildet ist, daß die globale Impulsantwort G(z) des Filters (2) und der Schaltung (3) minimale Phase besitzen, das Verfahren folgende Schritte aufweist:

- Bestimmung der Frequenzantwort H(f) des Filters (2) durch die Fourier-Transformierte der Impulsantwort H(z) dieses Filters (2),
- Bestimmung des reellen Teils a(f) der Cepstre-Größe $\hat{H}$(f) = -ln(H(f)) der Impulsantwort H(f) des Filters (2), um aus diesem reellen Teil a(f) einen geradzahligen Teil p(f) und einen ungeradzahligen Teil q(f) zu entnehmen,
- Bestimmung der Cepstre-Größe $\hat{G}$(f) = -ln(G(f)) der globalen Frequenzantwort ausgehend von dem geradzahligen Teil p(f) und dem ungeradzahligen Teil q(f) der Cepstre-Größe $\hat{H}$(f) er Impulsantwort des Filters (2),
- Bestimmung der globalen Frequenzantwort G(f) ausgehend von der Cepstre-Größe $\hat{G}$(f) dieser Antwort,
- Bestimmung der theoretischen Frequenzantwort C(f) der Filterschaltung (3) mit Hilfe der globalen Frequenzantwort G(f) und der Frequenzantwort H(f) des Filters (2),
- Berechnung der theoretischen Transmittanz C(z) der Filterschaltung (3) durch die inverse Fourier-Transformierte der Frequenzantwort C(f) dieser Schaltung (3),
- und Bestimmung der Transmittanz P(z) der Filterschaltung (3) durch Abbruch der Entwicklung der Transmittanz C(z), von der nur eine vorbestimmte Anzahl von Koeffizienten beibehalten bleiben.

**2.** Verfahren nach Anspruch 1, dadurch gekennzeichnet, daß es eine Abschätzung der globalen Impulsantwort G(z) ausgehend von einer begrenzten Entwicklung der Cepstre-Größe $\hat{G}_i$(z) erlaubt.

**3.** Verfahren nach einem der Ansprüche 1 oder 2, dadurch gekennzeichnet, daß außerdem eine erste Abschätzung $\hat{G}_0$(z) der Antwort mit minimaler Phase G(z) erhalten wird, zu der folgende Schritte gehören:

- eine Berechnung der Koeffizienten der Impulsantwort mit minimaler Phase G(z) durch diskrete inverse Fourier-Transformierte der Frequenzantwort mit minimaler Phase G(f),
- und Beibehaltung einer bestimmten Anzahl von signifikanten Koeffizienten, um die Abschätzung $\tilde{G}_0$(z) zu erhalten.

**4.** Verfahren nach einem beliebigen der vorhergehenden Ansprüche, dadurch gekennzeichnet, daß außerdem eine zweite Abschätzung $\widetilde{G}_i$(z) in Form des kausalen Teils des Produkts aus der Impulsantwort des Filters H(z) und des Schätzwerts $\widetilde{P}$(z) der Transmittanz P(z) des Filters (3) erfolgt.

**5.** Verfahren nach einem beliebigen der vorhergehenden Ansprüche, dadurch gekennzeichnet, daß es eine feste und von der Länge des Filters H(z) unabhängige Anzahl von durchzuführenden Operationen und eine feste Zeitdauer erfordert und daß die abgebrochenen Entwicklungen und die Transformierten vorgegebene Größen besitzen.

**6.** Verfahren nach einem beliebigen der vorhergehenden Ansprüche, dadurch gekennzeichnet, daß außerdem eine heuristische Behandlung des Falles erfolgt, daß die Impulsantwort H(z) des Filters (2) Nullstellen auf dem Einheitskreis besitzt, und zwar durch folgende Änderung:

$$a(f) = 1/2 \ln(H(f)H^*(f) + \varepsilon),$$

wobei $\varepsilon$ einen Regelparameter darstellt.

**7.** Digitale transversale Filterschaltung zur Phasenkorrektur (3) in Verbindung mit einem Filter (2), um die globale Impulsantwort des Filters (2) und der Filterschaltung (3) auf minimale Phase zu bringen, mit algorithmischen Rechenmitteln (1) in Verbindung mit der Filterschaltung (3) zur Korrektur, um deren Koeffizienten durch Einsatz des Verfahrens nach einem beliebigen der obigen Ansprüche anzupassen.

## Claims

**1.** Method for determining the transmittance P(z) of a filter circuit (3) associated with a filter (2) having an impulse response H(z), characterised in that, said filter circuit (3) being such that the global impulse response G(z) of said filter (2) and said circuit (3) is a minimal phase response, it comprises:

- determining the frequency response H(f) of said filter (2) as the Fourier transform of the impulse response H(z) of said filter (2),
- determining the real part a(f) of the cepstrum $\hat{H}(f) = -\ln(H(f))$ of the impulse response H(f) of said filter (2) to extract from said real part a(f) an even part p(f) and an odd part q(f),
- determining the cepstrum $\hat{G}(f) = -\ln(G(f))$ of the global frequency response from said even part p(f) and said odd part q(f) of said cepstrum $\hat{H}(f)$ of the impulse response of said filter (2),
- determining the global frequency response G(f) from said cepstrum $\hat{G}(f)$ of said response,
- determining the theoretical frequency response C(f) of said filter circuit (3) by means of the global frequency response G(f) and the frequency response H(f) of said filter (2),
- calculating the theoretical transmittance C(z) of said filter circuit (3) as the inverse Fourier transform of the frequency response C(f) of said circuit (3), and
- determining the transmittance P(z) of said filter circuit (3) by truncating said transmittance C(z) by retaining only a predetermined number of coefficients thereof.

**2.** Method according to claim 1 characterised in that it enables estimation of the global impulse response G(z) from a limited expansion of said cepstrum $\hat{G}(z)$.

**3.** Method according to claim 1 or claim 2 characterised in that it further comprises obtaining a first estimate $\tilde{G}_0(z)$ of said minimal phase response G(z) including:

- computing coefficients of said minimal phase impulse response G(z) as the inverse discrete Fourier transform of said minimal phase frequency response G(f), and
- retaining a predetermined number of significant coefficients to obtain said estimate $\tilde{G}_0(z)$.

**4.** Method according to any one of the preceding claims characterised in that it further comprises obtaining a second estimate $\tilde{G}_1(z)$ in the form of the causal part of the product of the filter impulse response H(z) and the estimate $\tilde{P}(z)$ of the transmittance P(z) of the filter (3).

**5.** Method according to any one of the preceding claims characterised in that it comprises a number of operations to be performed and a computation time that are fixed and independent of the length of said filter H(z) and in that said limited expansions and said transforms are of predetermined size.

**6.** Method according to any one of the preceding claims characterised in that it further comprises heuristic processing if the impulse response H(z) of the filter (2) has zeros on the unity circle, by application of the following modification:

$$a(f) = -1/2 \ln(H(f)H^*(f) + \varepsilon)$$

in which $\varepsilon$ represents an adjustment parameter.

7. Phase corrector digital transversal filter circuit (3) associated with a filter (2) and such that the global impulse response of said filter (2) and said filter circuit (3) is a minimal phase response, comprising algorithm-based computation means (1) associated with said filter circuit (3) to adapt the coefficients thereof by means of the method according to any one of the preceding claims.

FIG_1

FIG_2

FIG. 3

FIG. 4

FIG. 5